# EUROPÄISCHE PATENTSCHRIFT

(11) **EP 0 999 956 B1**
(45) Veröffentlichungstag und Bekanntmachung des Hinweises auf die Patenterteilung: **27.03.2002**
(21) Anmeldenummer: 98947306.1
(22) Anmeldetag: 17.07.1998
(51) Int. Cl.: B60R 21/00

(54) **ANORDNUNG UND VERFAHREN ZUM TESTEN EINER SCHALTUNGSVORRICHTUNG, DIE ZUM STEUERN EINES INSASSENSCHUTZMITTELS EINES KRAFTFAHRZEUGS VORGESEHEN IST**
SYSTEM AND METHOD FOR TESTING A CIRCUIT DEVICE FOR CONTROLLING AN AUTOMOBILE PASSENGER PROTECTION MECHANISM
DISPOSITIF ET PROCEDE POUR ESSAYER UN MONTAGE SERVANT A COMMANDER UN MOYEN DE PROTECTION D'OCCUPANT D'UN VEHICULE AUTOMOBILE

(30) Priorität: 29.07.1997 DE 19732677
(43) Veröffentlichungstag der Anmeldung: 17.05.2000
(73) Patentinhaber: SIEMENS AKTIENGESELLSCHAFT, 80333 München (DE)
(72) Erfinder: BELAU, Horst, D-84085 Langquaid (DE); ZELGER, Christian, D-93049 Regensburg (DE)
(86) Internationale Anmeldenummer: DE9802023
(87) Internationale Veröffentlichungsnummer: WO9906245

(56) Entgegenhaltungen:
- EP-A- 0 684 163
- EP-A- 0 701 928
- EP-A- 0 806 323
- WO-A-93/17893
- DE-A- 4 224 477
- DE-A- 4 445 093
- DE-A- 19 644 858

## Beschreibung

Die Erfindung betrifft eine Anordnung und ein Verfahren zum Testen einer Schaltungsvorrichtung, die zum Steuern eines Insassenschutzmittels eines Kraftfahrzeugs vorgesehen ist.

Es ist eine Schaltungsvorrichtung zum Steuern eines Insassenschutzmittels eines Kraftfahrzeugs bekannt (EP 0 684 163 B1), bei der ein Energiespeicherkondensator parallel zu einer Serienschaltung aus einer ersten steuerbaren Leistungsstufe, einem Zündelement des Insassenschutzmittels und einer weiteren steuerbaren steuerbaren Leistungsstufe angeordnet ist. Das Insassenschutzmittel in Form eines Airbags oder eines Gurtstraffers wird nur dann gezündet, wenn beide steuerbaren Leistungsstufen leitend geschaltet sind. Zum Überprüfen der Funktionsfähigkeit einer Leistungsstufe wird veranlaßt durch eine Steuerschaltung jeweils eine der Leistungsstufen zu Prüfzwecken geschlossen, wohingegen gleichzeitig die andere Leistungsstufe in sperrendem Zustand bleibt, so daß das Zündelement nicht gezündet wird. Jeweils ein Stromsensor ist jeder Leistungsstufe zugeordnet. Der während vorbeschriebener Prüfroutine ermittelte Strom läßt Rückschlüsse auf die Funktionsfähigkeit der überprüften Leistungsstufe zu.

Eine solche Serienschaltung bestehend aus zwei steuerbaren Leistungsstufen und einem Zündelement beansprucht insbesondere aufgrund der Anzahl steuerbarer Leistungsstufen bei ihrer Implementierung als integrierter Schaltkreis eine große Fläche und ist damit aufwendig und kostenintensiv herzustellen.

Die DE 42 24 477 A1 zeigt eine Anordnung beziehungsweise ein Verfahren zum Testen einer Schaltungsvorrichtung zum Steuern eines Insassenschutzmittels mit einer Parallelschaltung von Energiespeicherkondensator einerseits und von Zündelement und steuerbarer Leistungsstufe andererseits, wobei die Parallelschaltung von einer einen Teststrom liefernden Energiequelle versorgt wird.

Aus der WO 93/17893 A1 ist eine Schaltungsvorrichtung zum Steuern eines Insassenschutzmittels eines Kraftfahrzeugs bekannt, bei der ein Energiespeicher parallel zu einer Serienschaltung aus einem Zündelement und einer einzigen steuerbaren Leistungsstufe angeordnet ist. Das Insassenschutzmittel in Form eines Airbags oder eines Gurtstraffers wird dann gezündet, wenn der steuerbare Leistungsschalter leitend geschaltet wird. Bei einer solchen Schaltungsvorrichtung ist die Funktionsfähigkeit der steuerbaren Leistungsstufe nicht überprüfbar, da der Energiespeicherkondensator bei jedem Ansteuern zu Prüfzwecken über das Zündelement entladen wird. Ein unerwünschtes Auslösen des Insassenschutzmittels wäre die Folge.

Aufgabe der Erfindung ist es deshalb, die Nachteile der bekannten Anordnungen zu vermeiden und insbesondere eine Anordnung und ein Verfahren zum Testen einer Schaltungsvorrichtung für den Insassenschutz zu schaffen, die trotz geringer Bauelementeanzahl eine zuverlässige Funktionsüberprüfung zulässt.

Der die Anordnung betreffende Teil der Erfindungsaufgabe wird durch den Anspruch 1 gelöst. Der das Verfahren betreffende Teil der Erfindungsaufgabe wird durch die Merkmale des Anspruchs 10 gelöst.

Vorteilhafte Weiterbildungen der Erfindung sind durch die Merkmale der von Anspruch 1 und Anspruch 10 abhängigen Unteransprüche gekennzeichnet.

Die Erfindung, ihre Weiterbildungen und ihre Vorteile werden in Form von Ausführungsbeispielen anhand der Zeichnung näher erläutert. Es zeigen:
- Figur 1: ein Schaltbild einer ersten erfindungsgemäßen Anordnung,
- Figur 2: ein Schaltbild einer weiteren erfindungsgemäßen Anordnung, und
- Figur 3: ein Ablaufdiagramm für das erfindungsgemäße Verfahren zum Überprüfen der Funktionsfähigkeit einer Leistungsstufe in einer Anordnung gemäß Figur 1 oder Figur 2.

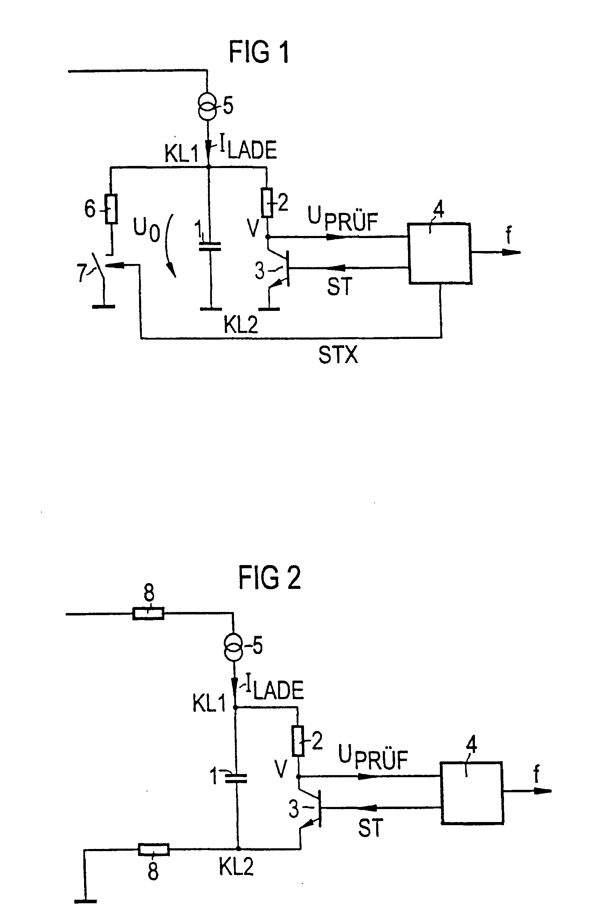

Figur 1 zeigt einen Schaltplan der erfindungsgemäßen Anordnung. Eine Energiequelle 5 in Form einer Stromquelle liefert einen Teststrom I_{LADE} für einen Parallelschaltkreis, enthaltend zum einen einen Energiespeicherkondensator 1 sowie eine Serienschaltung aus einem Zündelement 2 und einer steuerbaren Leistungsstufe 3. Klemmen KL1 und KL2 kennzeichnen diejenigen Schaltungspunkte, die mit der Energiequelle 5 verbunden sind. Ein Auswerter 4 steuert über eine Steuersignal ST die Leistungsstufe 3 sowie greift an dem Verbindungspunkt V zwischen Zündelement 2 und Leistungsstufe 3 eine Prüfspannung U_{PRÜF} ab, in diesem Fall bezogen auf Massepotential (Klemme KL2). Ferner kann der Auswerter 4 ein Fehlersignal f an seinem Ausgang liefern.

Vorbeschriebene Parallelschaltung enthält einen weiteren parallel zu dem Energiespeicherkondensator 1 und der vorbeschriebenen Serienschaltung 2,3 angeordneten Serienkreis, enthaltend einen Widerstand 6 und einen steuerbaren Schalter 7, der durch ein weiteres Steuersignal STX des Auswerters 4 betätigbar ist.

Der Kerngedanke der Erfindung liegt darin, daß bei entladenem Energiespeicherkondensator 1 das Schließvermögen der Leistungsstufe 3 überprüft werden kann. Dabei ist der von der Energiequelle 5 gelieferte Teststrom I_{LADE} derart bemessen, daß das Zündelement 2 bei seiner Beaufschlagung mit diesem Teststrom I_{LADE} noch nicht zündet. So weist der Teststrom I_{LADE} auch keinen derart hohen Pegel auf, als daß der Energierspeicherkondensator 1 innerhalb sehr kurzer Zeit auf seine Zündspannung U_{c} aufgeladen sein könnte. Führt nun ein Steuersignal ST des Auswerters 4 zum Übergang der Leistungsstufe 3 vom sperrenden in den leitenden Zustand bei gleichzeitig nahezu entladenem Energiespeicherkondensator 1, so fließt im folgenden der von der Energiequelle 5 gelieferte Teststrom I_{LADE} über das Zündelement 2 und die Leistungsstufe 3. Bleibt die Prüfspannung U_{PRÜF} in etwa konstant - wobei die Prüfspannung U_{PRÜF} hier in etwa gleich dem Massepotential ist, wenn sie als Potentialdifferenz zwischen dem Verbindungspunkt V und dem Massepotential KL2 und damit als Kollektor-Emitter-Spannung des Leistungstransistors 3 verstanden wird -, so ist angezeigt, daß sich die Leistungsstufe 3 von ihrem sperrenden in ihren leitenden Zustand umschalten läßt und damit funktionstüchtig ist. Steigt die Prüfspannung U_{PRÜF} jedoch an auf Werte wesentlich größer als das Bezugs- bzw. Massepotential KL2, so läßt sich die steuerbare Leistungsstufe 3 nicht von ihrem sperrenden in ihren leitenden Zustand überleiten und ist damit defekt. Ein Aufladen des Energiespeicherkondensators 1 durch den Teststrom I_{LADE} ist dann verantwortlich für den Anstieg der Prüfspannung U_{PRÜF.} Insbesondere wenn also die Prüfspannung U_{PRÜF} einen festgelegten Spannungswert oder einen festgelegten Anstieg überschreitet, liefert die Steuerschaltung 4 ein Fehlersignal f als Anzeichen für eine funktionsuntüchtige Leistungsstufe 3.

Wird die steuerbare Leistungsstufe 3 als schließbar festgestellt, so kann ferner durch Messung eines Spannungsabfalles am Zündelement 2 der Zündpillenwiderstand und/oder der von der Energiequelle 5 gelieferte Teststrom I_{L} überprüft werden. Damit kann auf die Funktionstüchtigkeit der Energiequelle 5 und des Zündelements 2 rückgeschlossen werden.

Nach dieser Überprüfung der Schließfähigkeit der steuerbaren Leistungsstufe 3 wird überprüft, ob die Leistungsstufe 3 aus ihrem sperrendem Zustand in ihren leitenden Zustand überführt werden kann. Ein entsprechendes Steuersignal ST wird wiederum von dem Auswerter 4 geliefert. Ist die Leistungsstufe 3 öffenbar und damit funktionstüchtig, so wirkt der von der Energiequelle 5 gelieferte Teststrom I_{LADE} gänzlich als Ladestrom für den Energiespeicherkondensator 1 und lädt diesen auf eine Zündspannung U_{Z} auf, aus der später, wenn ein Aufprall erkannt wird, gezündet wird. Damit steigt insbesondere auch das Potential am Verbindungspunkt V wesentlich an. Der Auswerter 4 überprüft die Prüfspannung U_{PRÜF} entweder während des Aufladens des Energiespeicherkondensators 1 oder nach einer festgelegten Zeitspanne, nach der eben der Energiespeicherkondensator 1 auf seine Zündspannung U_{Z} aufgeladen ist. Läßt sich die Leistungsstufe 3 nicht öffnen, so fließt der Teststrom I_{LADE} weiterhin über das Zündelement 2 und die Leistungsstufe 3: Die Prüfspannung U_{PRÜF} entspricht dann in etwa dem Massepotential an Klemme KL2 und ändert sich zeitlich nicht. Läßt sich die Leistungsstufe 3 jedoch öffenen, so steigt die Prüfspannung U_{PRÜF} auf einen Spannungswert, der wesentlich größer ist als das Massepotential an Klemme KL2. Erkennt also der Auswerter 4, daß die Prüfspannung U_{PRÜF} nach dem Ausgeben des Steuersignals ST zum Öffnen der Leistungsstufe 3 einen Mindestspannungsanstieg überschreitet, so gilt die Leistungsstufe 3 als öffenbar. Alternativ kann auch nach einer Mindestzeit nach Ausgabe des Steuersignals ST zum Öffnen des steuerbaren Schalters 3 die Prüfspannung U_{PRÜF} dahingehend überprüft werden, ob sie einen Mindestspannungswert überschreitet. Ist dies der Fall, so gilt auch in diesem Fall die Leistungsstufe 3 als öffenbar und damit funktionstüchtig. Erreicht jedoch das Prüfsignal U_{PRÜF} den Mindestspannungsanstieg bzw. den Mindestspannungswert nicht, so liegt eine funktionsuntüchtige Leistungsstufe 3 in dem Sinne vor, daß sie nicht vom geschlossenen in den offenen Zustand überführbar ist. In diesem Fall liefert der Auswerter 4 ein Fehlersignal f. Gleichzeitig mit der Überprüfung der Öffenbarkeit der Leistungsstufe 3 wird die Funktionstüchtigkeit des Energiespeicherkondensators 1 und der Stromquelle 5 mitüberprüft.

Der wesentliche Vorteil der erfindungsgemäßen Anordnung und des erfindungsgemäßen Verfahrens liegt darin, daß trotz Verwendung nur einer einzigen steuerbaren Leistungsstufe 3 in einem Zündkreis für ein Insassenschutzmittel wie Airbag, Gurtstraffer o.ä. selbige Leistungsstufe 3 sowohl auf Öffenbarkeit als auch auf Schließbarkeit getestet werden kann, ohne daß das in Serie zur Leistungsstufe 3 angeordnete Zündelement 2 gezündet wird. Die Anzahl der eingesetzten Bauelemente ist minimiert. Je individuell anzusteuerndes Zündelement ist also jeweils nur ein einziger steuerbarer Leistungsschalter erforderlich.

Die Energiequelle 5 ist insbesondere ein Stromquelle, die einen eingeprägten Teststrom I_{LADE} liefert. Alternativ kann eine Spannungsquelle verwendet werden, die jedoch einen relativ hohnen Innenwiderstand aufweisen muß, um ebenfalls einen nahezu lastunabhängigen eingeprägten und damit insbesondere begrenzten Teststrom I_{LADE} liefern zu können. Lädt beispielsweise der Teststrom I_{LADE} bei geöffneter Leistungsstufe 3 den Energiespeicherkondensator 1 mit einer zu großen Zeitkonstante auf, kann für das Aufladen des Energiespeicherkondensators 1 - also nach dem Testen der Schließbarkeit der Leistungsstufe 3 - der Teststrom auch einen höheren Wert annehmen. Das Zündelement 2 ist einem Insassenschutzmittel derart zugeordnet, daß als Reaktion auf seine Zündung z. B. Gas freigesetzt wird, das einen Airbag oder zumindest einen Teil eines Airbags füllt. Die steuerbare Leistungsstufe ist vorzugsweise ein steuerbarer Leitungstransistor, der für einen zum Zünden des Zündelements 2 vorgesehenen Zündstrom aus dem Energiespeicherkondensator 1 ausgelegt ist. Der Auswerter 4 führt nicht nur Auswerteroutinen aus sondern insbesondere auch Steuerroutinen und ist vorzugsweise ein Mikroprozessor, kann aber auch als Analogschaltung oder sonstige Meß- und/oder Steuer- und/oder Auswerteeinrichtung ausgebildet sein. In ihrer Anordnung relativ zur Energiequelle können auch steuerbare Leistungsstufe 3 und Zündelement 2 miteinander vertauscht angeordnet sein, so daß gemäß Figur 1 beispielsweise das Zündelement 2 mit dem Massepotential KL2 verbunden ist. Ebenso kann die Prüfspannung U_{PRUF} nicht nur auf Massepotential als zweite Klemme KL2 der Energiequelle 5 sondern natürlich auch auf die erste Klemme KL1 bezogen sein. Die Auswertung der Prüfspannung U_{PRÜF} hinsichtlich Vorzeichen und Mindestschwellen ist dementsprechend anzupassen.

Vor der Überprüfung der Schließfähigkeit der Leistungsstufe 3 wird vorzugsweise überprüft, ob der Energiespeicherkondensator 1 zumindest soweit entladen ist, daß seine Restladung nicht mehr zu einem Zünden des Zündelements 2 bei geschlossener Leistungsstufe 3 führen kann. Dazu wird vorzugsweise die Kondensatorspannung U_{C} vom Auswerter 4 überwacht. Ist die Kondensatorspannung U_{C} kleiner als eine Mindestschwelle, so gilt der Energiespeicherkondensator 1 als nahezu entladen. Nach dieser Überprüfung wird das vorbeschriebene Verfahren gestartet. Ist der Energiespeicherkondensator 1 nicht auf das notwendige Mindestmaß entladen, so kann er beispielsweise vor Beginn des vorbeschriebenen Verfahrens durch ein entsprechendes Steuersignal STX der Steuerschaltung 4, welches den steuerbaren Schalter 7 schließt, über den Widerstand 6 entladen werden, bevor im folgenden Schritt die Leistungsstufe 3 durch das Steuersignal ST von ihrem gesperrten in ihren leitenden Zustand übergeht und daraufhin die Prüfspannung U_{PRÜF} gemessen und verarbeitet wird. Vorzugsweise ist nach dem gesteuerten Entladen des Energergiespeicherkondensators 1 und vor der Funktionsüberprüfung auf Schließbarkeit der Leistungsstufe 3 nochmals der Ladezustand des Energiespeicherkondensators 1 zu überprüfen.

Durch Auswertung der Zündspannung U_{C} des Energiespeicherkondensators 1 oder der Prüfspannung U_{Prüf} während des Ladevorgangs bei geöffneter Leistungsstufe 3, z.B. durch Auswertung des Spannungsanstiegs oder des Spannungswertes zu einem festgelegten Meßzeitpunkt, können ferner Rückschlüsse auf seine Kapazität gewonnen werden. Dabei ergibt sich die Kapazität C des Kondensators 1 aus der Gleichung du/dt = I_{LADE}/C, wobei du/dt die Spannungsänderung während des Aufladens des Kondensators 1 ist.

Nach Beendigung der erfindungsgemäßen Prüfverfahren führt ein Schließen der Leistungsstufe 3 durch die Steuerschaltung 4 bei auf Zündspannung U_{Z} aufgeladenem Energiespeicherkondensator zum Zünden des Zündelements 2. Dazu verarbeitet der Auswerter 4 insbesondere durch geeignete Sensorik aufgenommene Aufprallsignale des Fahrzeugs und liefert erst dann ein entsprechendes Steuersignal ST zum Auslösen des Zündelements 2, wenn ein Aufprall als ausreichend stark für ein Auslösen von Insassenschutzmitteln angesehen wird.

Figur 2 unterscheidet sich von Figur 2 im wesentlichen nur darin, daß an die Klemme KL2 und die Klemme KL1 bzw. die Energiequelle 5 hochohmige Entkoppelwiderstände 8 angeschlossen sind. Diese Entkoppelwiderstände 8 bewirken, daß bei einem Kurzschluß einer der Anschlußklemmen des Zündelements 2 gegen eines der Versorgungspotentiale in jedem Fall die im Energiespeicherkondensator 1 gespeicherte Energie nicht in dem Maße über das Zündelement 2 abgegeben wird, daß der zum Zünden notwendige Zündstrom erreicht würde.

Die Schaltungsvorrichtung kann räumlich im Fahrzeug auf unterschiedliche Art angeordnet sein. So ist beispielsweise gemäß Figur 2 die gesamte Schaltungsvorrichtung mit Ausnahme des Zündelements 2 in einem gemeinsamen, vorzugsweise zentral im Fahrzeug angeordneten Steuergerät untergebracht. Das Zündelement 2 ist über Zündleitungen mit dem Steuergerät verbunden. Alternativ kann die gesamte Schaltungsvorrichtung gemäß Figur 2 in räumlicher Nähe bei dem Insassenschutzmittel angeordnet sein, wobei an die Entkoppelwiderstände 8 eine Leitung zur Energieversorgung angebracht ist, welche beispielsweise direkt mit dem Bordnetz oder einem zentralen Steuergerät für den Personenschutz verbunden ist. Insbesondere können bei einer solchen dezentralen Anordnung der Schaltungsvorrichtung auch Nachrichten in Form von Daten über die an Koppelwiderstände 8 angeschlossene Leitung übermittelt werden. Solche Nachrichten enthalten z. B. einen Zündbefehl zum Zünden des Zündelements 2, Diagnosebefehle oder Diagnoseergebnisse oder Initialisierungsnachrichten. Der Datenstrom wird ausgekoppelt und der Steuerschaltung 4 zugeführt, die die kodierten Nachrichten entschlüsselt und ggf. die Leistungsstufe 3 öffnet oder schließt. Die angeschlossene Leitung ist insbesondere als Bus ausgeführt, an den mehrere vorbeschriebene Schaltungsvorrichtungen über Entkoppelwiderstände 8 angeschlossen sind. Die Entkoppelwiderstände 8 bewirken dann, daß bei einem Kurzschluß in einer Schaltungsvorrichtung - z.B. als Folge des Zündens des Zündelements - nicht der gesamte Bus kurzgeschlossen wird und ein Zünden der weiteren Schaltungsvorrichtungen nicht mehr möglich ist.

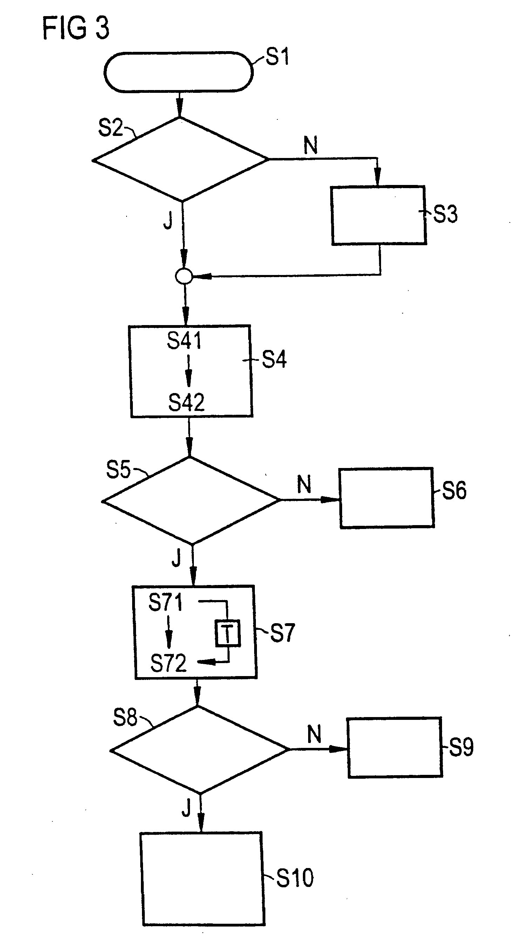

Figur 3 zeigt ein Ausführungsbeispiel des erfindungsgemäßen Verfahrens. In Schritt S1 wird die erfindungsgemäße Prüfroutine zum Überprüfen der Funktionsfähigkeit des Leistungsschalters 3 einer Schaltungsanordnung gemäß Figur 1 oder Figur 2 eingeleitet: Dabei wird in Schritt S2 überprüft, ob der Energiespeicherkondensator 1 zumindest weitgehend entladen ist. Ist der Energiespeicherkondensator 1 weitgehend entladen, folgt Schritt S4, ist der Energiespeicherkondensator 1 nicht entladen, wird er im Schritt 3 nahezu vollständig entladen. Im Schritt S4 wird zunächt die Leistungsstufe 3 vom sperrenden in den leitenden Zustand überführt - Schritt S41 - bevor die Prüfspannung U_{PRÜF} aufgenommen wird - Schritt S42. Im Schritt S5 wird überprüft, ob die Prüfspannung U_{PRÜF} einen Mindestspannungswert überschreitet: ist dem nicht so, wird im Schritt S6 ein Fehlersignal f erzeugt, da die Leistungsstufe offensichtlich nicht leitend geschalten werden kann. Unterschreitet jedoch die Prüfspannung U_{PRÜF} den Mindestspannungswert, so wird im folgenden im Schritt S7 zunächst die Leistungsstufe 3 derart angesteuert, daß sie öffnen soll - Schritt S71. Daraufhin wird eine festgelegte Zeit T abgewartet, bevor die Prüfspannung U_{PRÜF} mit einem weiteren Schwellwert verglichen wird, welcher gegebenenfalls gleich dem Mindestschwellwert aus Schritt S5 ist. Überschreitet die Prüfspannung U_{PRÜF} diesen Schwellwert, so wird im Schritt S10 mit dem normalen Funktionsbetrieb der Schaltungsvorrichtung zum Steuern eines Insassenschutzmittels fortgefahren. Andernfalls wird im Schritt S9 wiederum ein Fehlersignal f - optisch oder akustisch - erzeugt, da die Leistungsstufe 3 offensichtlich nicht von dem leitenden in den nichtleitenden Zustand überführt werden kann.

Das Überprüfungsverfahren gemäß Figur 3 kann während des Normalbetriebs der Schaltungsvorrichtung - also bei eingeschalteter Fahrzeugzündung - durchgeführt werden, wobei dann in jedem Fall der Schritt S3 zum Entladen des Energiespeicherkondensators erforderlich ist. Wird das vorgeschlagene Verfahren bei Inbetriebnahme der Steuervorrichtung, also beim Starten des Fahrzeugs durch die Fahrzeugzündung durchgeführt, so ist der Energiespeicherkondensator gewöhnlich im entladenen Zustand.

## Patentansprüche (Patentansprüche für folgende(n) Vertragsstaat(en): DE, FR, GB, IT, SE, ES)

1. Anordnung zum Testen einer Schaltungsvorrichtung, die zum Steuern eines Insassenschutzmittels eines Kraftfahrzeugs vorgesehen ist,
- bei der die Schaltungsvorrichtung einen Energiespeicherkondensator (1) aufweist, der parallel zu einer Serienschaltung aus einem Zündelement (2) und einer steuerbaren Leistungsstufe (3) angeordnet ist,
- bei der die Parallelschaltung von einer einen Teststrom (I_{LADE}) liefernden Energiequelle (5) versorgt wird,
- bei der bei zumindest weitgehend entladenem Energiespeicherkondensator (1) und bei leitend geschaltener Leistungsstufe (3) eine in der Serienschaltung (2,3) abfallende Prüfspannung (U_{PRÜF}) durch einen Auswerter (4) aufgenommen und ausgewertet wird, und
- bei der die Schaltungsvorrichtung mit einem zentralen Steuergerät für den Personenschutz über eine Leitung verbunden ist.

2. Anordnung nach Anspruch 1, bei der die Prüfspannung (U_{PRÜF}) zwischen Verbindungspunkt (V) von Zündelement (2) und Leistungsstufe (3) und einer Klemme der Energiequelle (KL1,KL2) abgegriffen wird.

3. Anordnung nach einem der vorhergehenden Ansprüche, bei der der Auswerter (4) anhand eines Spannungsabfalls (U_{c}) an dem Energiespeicherkondensator (1) überprüft, ob der Energiespeicherkondensator (1) zumindest weitgehend entladen ist, und bei der erst dann die Leistungsstufe (3) durch den Auswerter (4) zu Prüfzwecken leitend geschaltet wird, wenn festgestellt ist, daß der Energiespeicherkondensator (1) zumindest weitgehend entladen ist.

4. Anordnung nach einem der vorhergehenden Ansprüche, bei der der von der Energiequelle (1) gelieferte Teststrom (I_{LADE}) kleiner ist als ein zum Zünden des Zündelements (2) erforderlicher Zündstrom (I_{ZÜND}).

5. Anordnung nach einem der vorhergehenden Ansprüche, bei der in Abhängigkeit von der Auswertung der Prüfspannung (U_{PRÜF}) durch den Auswerter (4) ein Fehlersignal (f) erzeugt wird.

6. Anordnung nach einem der vorhergehenden Ansprüche, bei der die Leistungsstufe (3) nach ihrem Leitendschalten zu Prüfzwecken sperrend geschaltet wird und daraufhin die Prüfspannung (U_{PRÜF}) von dem Auswerter (4) aufgenommen und ausgewertet wird.

7. Anordnung nach Anspruch 6, bei der die Prüfspannung (U_{PRÜF}) nach einer festgelegten Zeitspanne (T) ab Sperrendschalten der Leistungsstufe (3) aufgenommen und ausgewertet wird.

8. Anordnung nach einem der Ansprüche 6 oder 7, bei der in Abhängigkeit von der Auswertung der nach dem Sperrendschalten der Leistungsstufe (3) ermittelten Prüfspannung (U_{PRÜF}) ein Fehlersignal (f) erzeugt wird.

9. Anordnung nach einem der vorhergehenden Ansprüche, bei der in Serie zu dem Parallelkreis (1,2,3) zumindest ein Entkoppelwiderstand (8) angeordnet ist.

10. Verfahren zum Testen einer Schaltungsvorrichtung, die zum Steuern eines Insassenschutzmittels eines Kraftfahrzeugs vorgesehen ist, wobei die Schaltungsvorrichtung eine Parallelschaltung aus einem Energiespeicherkondensator (1) und einer Serienschaltung aus einem Zündelement (2) und einer steuerbaren Leistungsstufe (3) aufweist, wobei die Parallelschaltung von einer einen Teststrom (I_{LADE}) liefernden Energiequelle (5) versorgt wird, und wobei die Schaltungsvorrichtung über eine Leitung mit einem zentralen Steuergerät für den Personenschutz verbunden ist,
- bei dem bei zumindest weitgehend entladenem Energiespeicherkondensator (1) die Leistungsstufe (3) leitend geschaltet wird, und
- bei dem nach dem Leitendschalten der Leistungsstufe (3) eine in der Serienschaltung (2,3) abfallende Prüfspannung (U_{PRÜF}) aufgenommen und ausgewertet wird.

11. Verfahren nach Anspruch 10, bei dem die Leistungsstufe (3) nach ihrem Leitendschalten sperrend geschaltet wird, und bei dem daraufhin die Prüfspannung (U_{PRÜF}) aufgenommen und ausgewertet wird.

## Patentansprüche (Patentansprüche für folgende(n) Vertragsstaat(en): FI, NL)

1. Anordnung zum Testen einer Schaltungsvorrichtung, die zum Steuern eines Insassenschutzmittels eines Kraftfahrzeugs vorgesehen ist,
- bei der die Schaltungsvorrichtung einen Energiespeicherkondensator (1) aufweist, der parallel zu einer Serienschaltung aus einem Zündelement (2) und einer steuerbaren Leistungsstufe (3) angeordnet ist,
- bei der die Parallelschaltung von einer einen Teststrom (I_{LADE}) liefernden Energiequelle (5) versorgt wird, und
- bei der bei zumindest weitgehend entladenem Energiespeicherkondensator (1) und bei leitend geschaltener Leistungsstufe (3) eine in der Serienschaltung (2,3) abfallende Prüfspannung (U_{PRÜF}) durch einen Auswerter (4) aufgenommen und ausgewertet wird.

2. Anordnung nach Anspruch 1, bei der die Prüfspannung (U_{PRÜF}) zwischen Verbindungspunkt (V) von Zündelement (2) und Leistungsstufe (3) und einer Klemme der Energiequelle (KL1,KL2) abgegriffen wird.

3. Anordnung nach einem der vorhergehenden Ansprüche, bei der der Auswerter (4) anhand eines Spannungsabfalls (U_{C}) an dem Energiespeicherkondensator (1) überprüft, ob der Energiespeicherkondensator (1) zumindest weitgehend entladen ist, und bei der erst dann die Leistungsstufe (3) durch den Auswerter (4) zu Prüfzwecken leitend geschaltet wird, wenn festgestellt ist, daß der Energiespeicherkondensator (1) zumindest weitgehend entladen ist.

4. Anordnung nach einem der vorhergehenden Ansprüche, bei der der von der Energiequelle (1) gelieferte Teststrom (I_{LADE}) kleiner ist als ein zum Zünden des Zündelements (2) erforderlicher Zündstrom (I_{ZÜND}).

5. Anordnung nach einem der vorhergehenden Ansprüche, bei der in Abhängigkeit von der Auswertung der Prüfspannung (U_{PRÜF}) durch den Auswerter (4) ein Fehlersignal (f) erzeugt wird.

6. Anordnung nach einem der vorhergehenden Ansprüche, bei der die Leistungsstufe (3) nach ihrem Leitendschalten zu Prüfzwecken sperrend geschaltet wird und daraufhin die Prüfspannung (U_{PRÜF}) von dem Auswerter (4) aufgenommen und ausgewertet. wird.

7. Anordnung nach Anspruch 6, bei der die Prüfspannung (U_{PRÜF}) nach einer festgelegten Zeitspanne (T) ab Sperrendschalten der Leistungsstufe (3) aufgenommen und ausgewertet wird.

8. Anordnung nach einem der Ansprüche 6 oder 7, bei der in Abhängigkeit von der Auswertung der nach dem Sperrendschalten der Leistungsstufe (3) ermittelten Prüfspannung (U_{PRÜF}) ein Fehlersignal (f) erzeugt wird.

9. Anordnung nach einem der vorhergehenden Ansprüche, bei der in Serie zu dem Parallelkreis (1,2,3) zumindest ein Entkoppelwiderstand (8) angeordnet ist.

10. Verfahren zum Testen einer Schaltungsvorrichtung, die zum Steuern eines Insassenschutzmittels eines Kraftfahrzeugs vorgesehen ist, wobei die Schaltungsvorrichtung eine Parallelschaltung aus einem Energiespeicherkondensator (1) und einer Serienschaltung aus einem Zündelement (2) und einer steuerbaren Leistungsstufe (3) aufweist, wobei die Parallelschaltung von einer einen Teststrom (I_{LADE}) liefernden Energiequelle (5) versorgt wird,
- bei dem bei zumindest weitgehend entladenem Energiespeicherkondensator (1) die Leistungsstufe (3) leitend geschaltet wird, und
- bei dem nach dem Leitendschalten der Leistungsstufe (3) eine in der Serienschaltung (2,3) abfallende Prüfspannung (U_{PRÜF}) aufgenommen und ausgewertet wird.

11. Verfahren nach Anspruch 10, bei dem die Leistungsstufe (3) nach ihrem Leitendschalten sperrend geschaltet wird, und bei dem daraufhin die Prüfspannung (U_{PRÜF}) aufgenommen und ausgewertet wird.

## Claims (Claims for the following Contracting State(s): DE, FR, GB, IT, SE, ES)

1. Arrangement for testing a circuit apparatus provided for controlling an occupant protection means for a motor vehicle,
- in which the circuit apparatus has an energy storage capacitor (1) which is arranged in parallel with a series circuit comprising a triggering element (2) and a controllable power stage (3),
- in which the parallel circuit is supplied from an energy source (5) delivering a test current (I_{CHARGE}),
- in which, when the energy storage capacitor (1) is at least largely discharged and when the power stage (3) is turned on, a test voltage (U_{TEST}) across the series circuit (2, 3) is taken up and evaluated by an evaluator (4), and
- in which the circuit apparatus is connected via a line to a central control unit for personal protection.

2. Arrangement according to Claim 1, in which the test voltage (U_{TEST}) is tapped off between the junction point (V) between the triggering element (2) and the power stage (3) and a terminal of the energy source (KL1, KL2).

3. Arrangement according to one of the preceding claims, in which the evaluator (4) uses a voltage drop (U_{c}) across the energy storage capacitor (1) to check whether the energy storage capacitor (1) is at least largely discharged, and in which the power stage (3) is turned on by the evaluator (4) for test purposes only if it is established that the energy storage capacitor (1) is at least largely discharged.

4. Arrangement according to one of the preceding claims, in which the test current (I_{CHARGE}) delivered by the energy source (5) is smaller than a triggering current (I_{TRIG}) necessary for triggering the triggering element (2).

5. Arrangement according to one of the preceding claims, in which an error signal (f) is produced on the basis of evaluation of the test voltage (U_{TEST}) by the evaluator (4).

6. Arrangement according to one of the preceding claims, in which, having been turned on for test purposes, the power stage (3) is turned off and the test voltage (U_{TEST}) is then taken up and evaluated by the evaluator (4).

7. Arrangement according to Claim 6, in which the test voltage (U_{TEST}) is taken up and evaluated after a defined time period (T) starting from when the power stage (3) is turned off.

8. Arrangement according to one of Claims 6 and 7, in which an error signal (f) is produced on the basis of the evaluation of the test voltage (U_{TEST}) determined after the power stage (3) is turned off.

9. Arrangement according to one of the preceding claims, in which at least one decoupling resistor (8) is arranged in series with the parallel circuit (1, 2, 3).

10. Method of testing a circuit apparatus provided for controlling an occupant protection means for a motor vehicle, the circuit apparatus having a parallel circuit comprising an energy storage capacitor (1) and a series circuit comprising a triggering element (2) and a controllable power stage (3), with the parallel circuit being supplied from an energy source (5) delivering a test current (I_{CHARGE}), and the circuit apparatus being connected via a line to a central control unit for personal protection,
- in which, when the energy storage capacitor (1) is at least largely discharged, the power stage (3) is turned on, and
- in which, after the power stage (3) has been turned on, a test voltage (U_{TEST}) across the series circuit (2, 3) is taken up and evaluated.

11. Method according to Claim 10, in which, having been turned on, the power stage (3) is turned off, and in which the test voltage (U_{TEST}) is then taken up and evaluated.

## Claims (Claims for the following Contracting State(s): FI, NL)

1. Arrangement for testing a circuit apparatus provided for controlling an occupant protection means for a motor vehicle,
- in which the circuit apparatus has an energy storage capacitor (1) which is arranged in parallel with a series circuit comprising a triggering element (2) and a controllable power stage (3),
- in which the parallel circuit is supplied from an energy source (5) delivering a test current (I_{CHARGE}), and
- in which, when the energy storage capacitor (1) is at least largely discharged and when the power stage (3) is turned on, a test voltage (U_{TEST}) across the series circuit (2, 3) is taken up and evaluated by an evaluator (4).

2. Arrangement according to claim 1, in which the test voltage (U_{TEST}) is tapped off between the junction point (V) between the triggering element (2) and the power stage (3) and a terminal of the energy source (KL1, KL2).

3. Arrangement according to one of the preceding claims, in which the evaluator (4) uses a voltage drop (U_{C}) across the energy storage capacitor (1) to check whether the energy storage capacitor (1) is at least largely discharged, and in which the power stage (3) is turned on by the evaluator (4) for test purposes only if it is established that the energy storage capacitor (1) is at least largely discharged.

4. Arrangement according to one of the preceding claims, in which the test current (I_{CHARGE}) delivered by the energy source (5) is smaller than a triggering current (I_{TRIG}) necessary for triggering the triggering element (2).

5. Arrangement according to one of the preceding claims, in which an error signal (f) is produced on the basis of evaluation of the test voltage (U_{TEST}) by the evaluator (4).

6. Arrangement according to one of the preceding claims, in which, having been turned on for test purposes, the power stage (3) is turned off and the test voltage (U_{TEST}) is then taken up and evaluated by the evaluator (4).

7. Arrangement according to Claim 6, in which the test voltage (U_{TEST}) is taken up and evaluated after a defined time period (T) starting from when the power stage (3) is turned off.

8. Arrangement according to one of Claims 6 and 7, in which an error signal (f) is produced on the basis of the evaluation of the test voltage (U_{TEST}) determined after the power stage (3) is turned off.

9. Arrangement according to one of the preceding claims, in which at least one decoupling resistor (8) is arranged in series with the parallel circuit (1, 2, 3).

10. Method of testing a circuit apparatus provided for controlling an occupant protection means for a motor vehicle, the circuit apparatus having a parallel circuit comprising an energy storage capacitor (1) and a series circuit comprising a triggering element (2) and a controllable power stage (3), with the parallel circuit being supplied from an energy source (5) delivering a test current (I_{CHARGE}),
- in which, when the energy storage capacitor (1) is at least largely discharged, the power stage (3) is turned on, and
- in which, after the power stage (3) has been turned on, a test voltage (U_{TEST}) across the series circuit (2, 3) is taken up and evaluated.

11. Method according to Claim 10, in which, having been turned on, the power stage (3) is turned off, and in which the test voltage (U_{TEST}) is then taken up and evaluated.

## Revendications (Revendications pour l'(les) Etat(s) contractant(s) suivant(s): DE, FR, GB, IT, SE, ES)

1. Dispositif pour essayer un montage servant à commander un moyen de protection d'occupant d'un véhicule automobile,
- dans lequel le montage comprend un condensateur d'accumulation d'énergie (1) installé en parallèle avec un câblage en série composé d'un élément de déclenchement (2) et d'un élément de puissance commandable (3),
- dans lequel le câblage en parallèle est alimenté par une source d'énergie (5) fournissant un courant d'essai (I_{CHARGE}),
- dans lequel une tension de contrôle (U_{CONTR}) en chute dans le câblage en série (2, 3) est captée et analysée par un élément d'analyse (4), le condensateur d'accumulation d'énergie (1) étant déchargé en majeure partie au moins et l'élément de puissance (3) se trouvant à l'état conducteur et
- dans lequel le montage est connecté par une ligne électrique à un dispositif central de commande de la protection de personnes.

2. Dispositif selon la revendication 1, dans lequel la tension de contrôle (U_{CONTR}) est captée entre le point de connexion (V) entre l'élément de déclenchement (2) et l'élément de puissance (3), et une borne de la source d'énergie (KL1, KL2).

3. Dispositif selon l'une des revendications précédentes, dans lequel l'élément d'analyse (4) contrôle, sur base d'une chute de tension (U_{C}) au niveau du condensateur d'accumulation d'énergie (1), si le condensateur d'accumulation d'énergie (1) est déchargé en majeure partie au moins et en ce que l'élément d'analyse (4) ne fait passer l'élément de puissance (3) à l'état conducteur que s'il a été constaté que le condensateur d'accumulation d'énergie (1) est déchargé en majeure partie au moins.

4. Dispositif selon l'une des revendications précédentes, dans lequel le courant d'essai (I_{CHARGE}) fourni par la source d'énergie (1) est inférieur à un courant de déclenchement (I_{DECL}) requis pour exciter l'élément de déclenchement (2).

5. Dispositif selon l'une des revendications précédentes, dans lequel l'élément d'analyse (4) génère un signal d'erreur (f) en fonction de l'analyse de la tension de contrôle (U_{CONTR}).

6. Dispositif selon l'une des revendications précédentes, dans lequel l'élément de puissance (3), après être passé à l'état conducteur pour contrôle, passe à l'état bloqué et en ce qu'ensuite la tension de contrôle (U_{CONTR}) est captée et analysée par l'élément d'analyse (4).

7. Dispositif selon la revendication 6, dans lequel la tension de contrôle (U_{CONTR}) est captée et analysée au terme d'une période définie (T) à compter du moment où l'élément de puissance (3) est passé à l'état bloqué.

8. Dispositif selon l'une des revendications 6 ou 7, dans lequel le signal d'erreur (f) est généré en fonction de l'analyse de la tension de contrôle (U_{CONTR}) mesurée suite au passage de l'élément de puissance (3) à l'état bloqué.

9. Dispositif selon l'une des revendications précédentes, dans lequel au moins une résistance de découplage (8) est installée en série avec le circuit d'éléments montés en parallèle (1, 2, 3).

10. Procédé pour essayer un montage servant à commander un moyen de protection d'occupant d'un véhicule automobile, le montage présentant un câblage en parallèle composé d'un condensateur d'accumulation d'énergie (1) et d'un câblage en série lui-même composé d'un élément de déclenchement (2) et d'un élément de puissance commandable (3), le câblage en parallèle étant alimenté par une source d'énergie (5) fournissant un courant d'essai (I_{CHARGE}) et le montage étant connecté par une ligne électrique à un dispositif central de commande de la protection de personnes,
- dans lequel l'élément de puissance (3) se trouve à l'état conducteur lorsque le condensateur d'accumulation d'énergie (1) est déchargé en majeure partie au moins, et
- dans lequel une tension de contrôle (U_{CONTR}) en chute dans le câblage en série (2, 3) est captée et analysée après que l'élément de puissance (3) est passé à l'état conducteur.

11. Procédé selon la revendication 10, dans lequel l'élément de puissance (3), après être passé à l'état conducteur, passe à l'état bloqué et en ce qu'ensuite la tension de contrôle (U_{CONTR}) est captée et analysée.

## Revendications (Revendications pour l'(les) Etat(s) contractant(s) suivant(s): FI, NL)

1. Dispositif pour essayer un montage servant à commander un moyen de protection d'occupant d'un véhicule automobile,
- dans lequel le montage comprend un condensateur d'accumulation d'énergie (1) installé en parallèle avec un câblage en série composé d'un élément de déclenchement (2) et d'un élément de puissance commandable (3),
- dans lequel le câblage en parallèle est alimenté par une source d'énergie (5) fournissant un courant d'essai (I_{CHARGE}),
- dans lequel une tension de contrôle (U_{CONTR}) en chute dans le câblage en série (2, 3) est captée et analysée par un élément d'analyse (4), le condensateur d'accumulation d'énergie (1) étant déchargé en majeure partie au moins et l'élément de puissance (3) se trouvant à l'état conducteur.

2. Dispositif selon la revendication 1, dans lequel la tension de contrôle (U_{CONTR}) est captée entre le point de connexion (V) entre l'élément de déclenchement (2) et l'élément de puissance (3), et une bome de la source d'énergie (KL1, KL2).

3. Dispositif selon l'une des revendications précédentes, dans lequel l'élément d'analyse (4) contrôle, sur base d'une chute de tension (U_{C}) au niveau du condensateur d'accumulation d'énergie (1), si le condensateur d'accumulation d'énergie (1) est déchargé en majeure partie au moins et en ce que l'élément d'analyse (4) ne fait passer l'élément de puissance (3) à l'état conducteur que s'il a été constaté que le condensateur d'accumulation d'énergie (1) est déchargé en majeure partie au moins.

4. Dispositif selon l'une des revendications précédentes, dans lequel le courant d'essai (I_{CHARGE}) fourni par la source d'énergie (1) est inférieur à un courant de déclenchement (I_{DECL}) requis pour exciter l'élément de déclenchement (2).

5. Dispositif selon l'une des revendications précédentes, dans lequel l'élément d'analyse (4) génère un signal d'erreur (f) en fonction de l'analyse de la tension de contrôle (U_{CONTR}).

6. Dispositif selon l'une des revendications précédentes, dans lequel l'élément de puissance (3), après être passé à l'état conducteur pour contrôle, passe à l'état bloqué et en ce qu'ensuite la tension de contrôle (U_{CONTR}) est captée et analysée par l'élément d'analyse (4).

7. Dispositif selon la revendication 6, dans lequel la tension de contrôle (U_{CONTR}) est captée et analysée au terme d'une période définie (T) à compter du moment où l'élément de puissance (3) est passé à l'état bloqué.

8. Dispositif selon l'une des revendications 6 ou 7, dans lequel un signal d'erreur (f) est généré en fonction de l'analyse de la tension de contrôle (U_{CONTR}) mesurée suite au passage de l'élément de puissance (3) à l'état bloqué.

9. Dispositif selon l'une des revendications précédentes, dans lequel au moins une résistance de découplage (8) est installée en série avec le circuit d'éléments montés en parallèle (1, 2, 3).

10. Procédé pour essayer un montage servant à commander un moyen de protection d'occupant d'un véhicule automobile, le montage présentant un câblage en parallèle composé d'un condensateur d'accumulation d'énergie (1) et d'un câblage en série lui-même composé d'un élément de déclenchement (2) et d'un élément de puissance commandable (3), le câblage en parallèle étant alimenté par une source d'énergie (5) fournissant un courant d'essai (I_{CHARGE}),
- dans lequel l'élément de puissance (3) se trouve à l'état conducteur lorsque le condensateur d'accumulation d'énergie (1) est déchargé en majeure partie au moins, et
- dans lequel une tension de contrôle (U_{CONTR}) en chute dans le câblage en série (2, 3) est captée et analysée après que l'élément de puissance (3) est passé à l'état conducteur.

11. Procédé selon la revendication 10, dans lequel l'élément de puissance (3), après être passé à l'état conducteur, passe à l'état bloqué et en ce qu'ensuite la tension de contrôle (U_{CONTR}) est captée et analysée.
